# EUROPÄISCHE PATENTSCHRIFT

(11) **EP 3 304 662 B1**
(45) Veröffentlichungstag und Bekanntmachung des Hinweises auf die Patenterteilung: **25.03.2020**
(21) Anmeldenummer: 16725514.0
(22) Anmeldetag: 25.05.2016
(51) Int. Cl.: H01S 5/10, H01S 5/02, H01S 5/022

(54) **HALBLEITERLASERDIODE UND VERFAHREN ZUR HERSTELLUNG EINER HALBLEITERLASERDIODE**
SEMI-CONDUCTOR LASER DIODE AND A METHOD FOR PRODUCING A SEMI-CONDUCTOR LASER DIODE
DIODE LASER SEMICONDUCTRICE ET PROCÉDÉ DE FABRICATION D'UNE DIODE LASER SEMICONDUCTRICE

(30) Priorität: 29.05.2015 DE 102015108529
(43) Veröffentlichungstag der Anmeldung: 11.04.2018
(73) Patentinhaber: OSRAM Opto Semiconductors GmbH, 93055 Regensburg (DE)
(72) Erfinder: EBBECKE, Jens, 93352 Rohr in Niederbayern (DE)
(74) Vertreter: Epping - Hermann - Fischer
(86) Internationale Anmeldenummer: PCT/EP2016/061835
(87) Internationale Veröffentlichungsnummer: WO 2016/193102

(56) Entgegenhaltungen:
- EP-A1- 1 544 967
- CN-Y- 2 422 764
- US-A1- 2012 320 939
- SHI-JIANG WANG ET AL: "AlGaInAs-InP Microcylinder Lasers Connected With an Output Waveguide", IEEE PHOTONICS TECHNOLOGY LETTERS, IEEE SERVICE CENTER, PISCATAWAY, NJ, US, Bd. 22, Nr. 18, 15. September 2010 (2010-09-15), Seiten 1349-1351, XP011312549, ISSN: 1041-1135
- ZIYUAN LI ET AL: "Coupling of light from microdisk lasers to nano-antennas with nano-tapers", PHOTONICS CONFERENCE (IPC), 2012 IEEE, IEEE, 23. September 2012 (2012-09-23), Seiten 889-890, XP032269368, DOI: 10.1109/IPCON.2012.6359280 ISBN: 978-1-4577-0731-5
- MECHET P ET AL: "Heterogeneously Integrated Microdisk Lasers for Optical Interconnects and Optical Logic", PROCEEDINGS OF THE SPIE - THE INTERNATIONAL SOCIETY FOR OPTICAL ENGINEERING SPIE - THE INTERNATIONAL SOCIETY FOR OPTICAL ENGINEERING USA, Bd. 7913, 23. Januar 2011 (2011-01-23), Seiten 791319-1-791319-9, XP40554338, ISSN: 0277-786X

## Beschreibung

Die Erfindung betrifft eine Halbleiterlaserdiode und ein Verfahren zur Herstellung einer Halbleiterlaserdiode.

Diese Patentanmeldung beansprucht die Priorität der deutschen Patentanmeldung 10 2015 108 529. 1.

Aus SHI-JIANG WANG "AlGaInAs-InP Microcylinder Lasers Connected With an Output Waveguide", IEEE PHOTONICS TECHNOLOGY LETTERS, Bd. 22, Nr. 18, 15. September 2010 , Seiten 1349-1351 ist ein Mikrozylinderlaser bekannt geworden, der mit einem Ausgangswellenleiter verbunden ist.

Aus US 2012/0320939 A1 ist ein Hybridlaser bekannt geworden, der einen auf InP basierenden Mikroscheibenlaser umfasst, wobei der Mikroscheibenlaser mit seiner n-dotierten Seite auf einen Siliziumwellenleiter gebondet ist.

Der Erfindung liegt die Aufgabe zugrunde, eine Halbleiterlaserdiode und ein Verfahren zur Herstellung einer solchen Halbleiterlaserdiode anzugeben, wobei sich die Halbleiterlaserdiode durch kleinskalige Größenabmessungen auszeichnet, einfach und kostengünstig herzustellen ist und einfach in mikrotechnologischen Anwendungen integriert werden kann.

Diese Aufgabe wird durch ein Erzeugnis und ein Verfahren gemäß den unabhängigen Patentansprüchen 1 und 11 gelöst. Vorteilhafte Ausgestaltungen und Weiterbildungen der Erfindung sind Gegenstand der abhängigen Ansprüche.

Eine Halbleiterlaserdiode erfordert einen Resonator für das Erzeugen einer stimulierten Emission. Dies erfordert üblicherweise Laserdioden als komplexe und verhältnismäßig teuer herzustellende Bauteile. Hierzu sind meist Spiegel als Braggstrukturen oder verspiegelte Oberflächen notwendig um eine Resonatorwirkung im Bauteil zu erzielen. Solche Halbleiterlaserdioden zeichnen sich meist durch entsprechend große Größenabmessungen aus.

Eine Halbleiterlaserdiode umfasst eine Halbleiterschichtenfolge umfassend eine aktive Zone, wobei die Halbleiterschichtenfolge zylinderförmig ist und eine Zylinderachse der Halbleiterschichtenfolge senkrecht zu einer Schichtebene der Halbleiterschichtenfolge ist. Weiterhin emittiert die Halbleiterlaserdiode eine im Betrieb erzeugte Strahlung senkrecht zur Zylinderachse der Halbleiterschichtenfolge.

Die Halbleiterschichtenfolge umfasst vorteilhaft einen p-dotierten Bereich und einen n-dotierten Bereich, wobei die aktive Zone insbesondere zwischen diesen beiden Bereichen angeordnet ist. Die Bereiche der Halbleiterschichtenfolge weisen hierbei vorteilhaft Schichtebenen auf, die parallel zueinander und übereinander angeordnet sind. Eine Zylinderachse steht dabei senkrecht auf den Schichtebenen, wobei die Form der Halbleiterschichtenfolge rotationssymmetrisch bezüglich der Zylinderachse ist. Die aktive Zone wird über den p- und n-dotierten Bereich elektrisch kontaktiert, wobei p- beziehungsweise n-Kontakte auf dem jeweiligen p- beziehungsweise n-dotierten Bereich angeordnet sein können.

Im Betrieb der Halbleiterlaserdiode erzeugt die aktive Zone Licht, welches in einer Richtung senkrecht zur Zylinderachse emittiert wird, und vorteilhaft an einer Stelle der zylinderförmigen Oberfläche aus der aktiven Zone ausgekoppelt wird.

Gemäß zumindest einer Ausführungsform der Halbleiterlaserdiode umfasst die aktive Zone eine bezüglich der Zylinderachse symmetrische Außenfläche, welche im Betrieb der Halbleiterlaserdiode durch Totalreflexion von in der aktiven Zone erzeugten Strahlung einen Resonator ausbildet.

In Draufsicht aus einer Richtung entlang der Zylinderachse weist die aktive Zone vorteilhaft eine kreisförmige Außenfläche auf. Die Außenfläche der aktiven Zone bildet entlang der Richtung der Zylinderachse im Bereich der aktiven Zone zumindest stellenweise die Außenfläche der Halbleiterlaserdiode. Eine solche Außenfläche zeichnet sich dadurch aus, dass in der aktiven Zone generierte Strahlung durch Totalreflexion an der Außenfläche reflektiert wird und im Inneren der aktiven Zone verbleibt. Mehrmalige Reflexion wirkt als ein Resonator für die Strahlung. Je perfekter hierbei die rotationssymmetrische Form beziehungsweise die Kreisform der Außenfläche ist, umso besser ist dabei die Wirkung der Totalreflexion an der Außenfläche für Strahlung aus dem Inneren der aktiven Zone. Ein Qualitätsfaktor Q des Resonators kann somit vorteilhaft durch die rotationssymmetrische Form beeinflusst werden. Etwaige Abweichungen von der rotationssymmetrischen Form der Außenfläche begünstigen demnach eine Auskopplung der Strahlung aus der aktiven Zone.

Bei einem Resonator mit einer Zylinderform, welche ausreichend kleinskalig ist, beispielsweise umfassend eine Grundfläche des Zylinders mit einem Durchmesser von 1 µm bis 100 µm, kann sich eine optische Resonatormode als "Whispering Gallery Mode" in der aktiven Zone ausbilden. Eine solche Resonatormode kann eine stimulierte Emission erzeugen.

Weiterhin ist es möglich zur Steigerung der Effizienz der Generierung von Strahlung, dass nichtstrahlende Verluste in der aktiven Zone, etwa resultierend aus Elektron-Loch-Rekombination, verringert werden. Hierzu eignen sich vorteilhaft Passivierungen oder Bereiche in der aktiven Zone mit lokalen p-Dotierungen, mittels welcher beispielsweise Barrieren für Elektronen innerhalb der aktiven Zone ausgebildet werden, so dass sich eine Verminderung der nichtstrahlende Rekombination an der Außenfläche bzw. am Außenbereich der aktiven Zone ergibt. Auf diese Weise wird die Effizienz des Resonators und die Effizienz der Abstrahlung der Halbleiterlaserdiode vorteilhaft vergrößert. Hierbei wird vorteilhaft eine Passivierung auf die Außenfläche der Halbleiterschichtenfolge aufgebracht, insbesondere auf die Außenfläche der aktiven Zone. Die Passivierung umgibt die Halbleiterschichtenfolge ringsum umlaufend vorteilhaft mit einer konstanten Dicke, so dass die Passivierung die Zylinderform der Halbleiterschichtenfolge beibehält.

Entsprechend kann zusätzlich zur Passivierung oder stattdessen ein Bereich der Halbleiterschichtenfolge, insbesondere der aktiven Zone, mit einer p-Dotierung im Außenbereich der Zylinderform ausgebildet werden. Hierbei werden nach dem Ausprägen der Zylinderform Akzeptoratome in die zylinderförmige Oberfläche der aktiven Zone eindiffundiert, so dass lokal an der Oberfläche der nominell undotierten aktiven Zone eine p-Dotierung erzeugt wird.

Gemäß zumindest einer Ausführungsform der Halbleiterlaserdiode umfasst die Außenfläche zumindest eine Austrittsstelle für die in der aktiven Zone im Betrieb erzeugte Strahlung.

Durch die Austrittsstelle kann die Strahlung aus der aktiven Zone austreten beziehungsweise ausgekoppelt werden. Hierbei ist es vorteilhaft, dass die Strahlung ausschließlich an dieser Austrittsstelle aus der aktiven Zone austritt. Weiterhin ist es auch denkbar, dass die aktive Zone an ihrer Außenfläche weitere Austrittsstellen für die Strahlung umfasst.

Gemäß zumindest einer Ausführungsform der Halbleiterlaserdiode weist die Außenfläche der aktiven Zone an der Austrittsstelle eine Abweichung von der Zylinderform auf, durch welche die in der aktiven Zone im Betrieb erzeugte Strahlung aus der Halbleiterlaserdiode austritt.

Im Bereich der Austrittsstelle weicht die Rotationssymmetrie der Außenfläche der aktiven Zone bezüglich der Zylinderachse vorteilhaft von der Zylinderform beziehungsweise von der Kreisform ab. In diesem Bereich ist der Grad der Totalreflexion verringert und die in der aktiven Zone resonierende Strahlung kann an dieser Austrittsstelle ausgekoppelt werden. Hierbei sind vorteilhaft alle denkbaren Oberflächenformen, beispielsweise konkave oder konvexe Bogenformen oder auch Aufrauungen möglich. Solche Abweichungen von der Rotationssymmetrie können vorteilhaft während dem Herstellungsprozess der Halbleiterschichtenfolge, insbesondere während dem Ausprägen der Zylinderform, erfolgen. Beispielsweise wird beim Herstellen der Zylinderform mittels eines Lithographieverfahrens beim Ätzen der Zylinderform gleichzeitig eine Deformation in der Zylinderform im Bereich der Austrittsstelle erzeugt.

Gemäß zumindest einer Ausführungsform der Halbleiterlaserdiode ist an der Austrittsstelle eine Auskoppelstruktur zur Auskopplung der in der aktiven Zone im Betrieb erzeugten Strahlung angeordnet.

Gemäß zumindest einer Ausführungsform der Halbleiterlaserdiode weist die Auskoppelstruktur einen von der aktiven Zone verschiedenen Brechungsindex auf.

Die Auskoppelstruktur ist vorteilhaft als separate Struktur umfassend ein Material, welches dem der aktiven Zone vor allem hinsichtlich des Brechungsindex verschieden ist, auf der Außenfläche der aktiven Zone angeordnet.

Gemäß zumindest einer Ausführungsform der Halbleiterlaserdiode umfasst die Auskoppelstruktur eine dielektrische Schicht und/oder eine plasmonische Struktur. Die dielektrische Schicht zeichnet sich vorteilhaft durch einen Unterschied im Brechungsindex, bezogen auf die aktive Zone, aus. Die dielektrische Schicht wird vorteilhaft nach Herstellung der Zylinderform, beispielsweise nach einem Ätzprozess, an der Austrittsstelle als zusätzliche Auskoppelstruktur aufgebracht.

Weiterhin ist es möglich, dass die Auskoppelstruktur eine plasmonische Struktur umfasst. Bei einer plasmonischen Struktur handelt es sich beispielsweise um eine nanoskalige Metallstruktur in Form eines Kreises, Rechtecks oder einer Gitterstruktur.

Weiterhin ist es auch möglich, dass die Auskoppelstruktur mehrere dielektrische Schichten und/oder plasmonische Strukturen aufweist.

Erfindungsgemäß umfasst die Halbleiterschichtenfolge eine p-dotierte Halbleiterschicht, wobei auf dieser eine Kontaktschicht angeordnet ist, wobei ein Brechungsindex der Kontaktschicht geringer ist als ein Brechungsindex der p-dotierten Halbleiterschicht.

Erfindungsgemäß ist an einer der Kontaktschicht zugewandten Seite ein Träger angeordnet.

Hierbei ist es vorteilhaft möglich, dass ein Aufwachssubstrat von der Halbleiterschichtenfolge entfernt wurde und der Träger vom Aufwachssubstrat für die Halbleiterschichtenfolge verschieden ist. Die p-dotierte Halbleiterschicht kann beispielsweise GaAs oder AlGaAs umfassen. Der Brechungsindex der p-dotierten Halbleiterschicht beträgt beispielsweise n = 3.4 für Licht einer Wellenlänge von 620 nm oder n = 2.4 für Licht einer Wellenlänge von 450 nm. Die Kontaktschicht umfasst beispielsweise ITO oder ZnO. Der Brechungsindex der Kontaktschicht beträgt beispielsweise n = 1,8 für ITO für Licht einer Wellenlänge von 620 nm und n = 2 für ZnO für Licht einer Wellenlänge von 620 nm. Auf diese Weise kann vorteilhaft eine Entkopplung des Resonators mit der Umgebung der Halbleiterlaserdiode verbessert werden. Durch eine verbesserte Entkopplung kann die Güte der Halbleiterlaserdiode verbessert werden. Die Entkopplung kann auch dadurch verbessert werden, dass die Halbleiterschichtenfolge möglichst wenig Kontakt zu einem Substrat oder Träger hat. Betreffen der Entkopplung des Resonators erweist sich ein Übertragen der Halbleiterschichtenfolge von einem Aufwachssubstrat auf einen Träger insbesondere bei Materialsystemen basierend auf Arseniden oder Phosphiden als vorteilhaft im Vergleich zu einem Verbleiben auf dem Aufwachssubstrat.

Gemäß zumindest einer Ausführungsform der Halbleiterlaserdiode weist eine Grundfläche der zylinderförmigen Halbleiterschichtenfolge einen Durchmesser von 1 µm bis 100 µm auf.

Eine solche Größenordnung der Halbleiterlaserdiode ergibt den Vorteil, dass diese gegenüber gängigen Halbleiterlaserdioden verhältnismäßig klein ist, wodurch sie einfach zu verbauen ist und mit geringem Aufwand als kostengünstiges Massenprodukt hergestellt werden kann. Eine solche Halbleiterlaserdiode kann vorteilhaft gut in mikrotechnologische Anwendungen integriert werden.

Gemäß zumindest einer Ausführungsform der Halbleiterlaserdiode umfasst die aktive Zone eine Einfachquantentopfstruktur oder eine Mehrfachquantentopfstruktur.

Zum effektiven Generieren einer stimulierten Emission in der Halbleiterlaserdiode ist in der aktiven Zone die Anwendung von wenigen Quantentopfstrukturen vorteilhaft. Insbesondere erweist sich die Anwendung von einer bis 10 Quantentopfstrukturen als vorteilhaft.

Gemäß zumindest einer Ausführungsform der Halbleiterlaserdiode umfasst die Halbleiterschichtenfolge eines der Materialsysteme InGaN, AlInGaP, oder AlGaAs.

Bei den Halbleiterschichten handelt es sich insbesondere um auf einem III-V-Halbleitermaterialien basierenden Halbleiterschichten. Beispielsweise basieren die Halbleiterschichten auf einem Nitrid-Verbindungshalbleitermaterial wie AlₙIn₁₋ₙGaₘN oder auf einem Phosphid-Verbindungshalbleitermaterial wie AlₙIn₁₋ₙGaₘP oder auf einem Arsenid-Verbindungshalbleitermaterial AlₙIn₁₋ₙGaₘAs, wobei jeweils 0 ≤ n ≤ 1, 0 ≤ m ≤ 1 und n+m ≤ 1 gilt. Dabei kann dieses Material einen oder mehrere Dotierstoffe sowie zusätzliche Bestandteile aufweisen. Der Einfachheit halber sind jedoch nur die wesentlichen Bestandteile des Kristallgitters, also Al, Ga, In, N oder P oder As, angegeben, auch wenn diese teilweise durch geringe Mengen weiterer Stoffe ersetzt und/oder ergänzt sein können.

Bei einem Verfahren zur Herstellung einer Halbleiterlaserdiode wird eine Halbleiterschichtenfolge mit einer aktiven Zone bereitgestellt, und eine Zylinderform der Halbleiterschichtenfolge mittels eines Ätzprozesses hergestellt, wobei die Halbleiterschichtenfolge eine Zylinderachse senkrecht zu einer Schichtebene der Halbleiterschichtenfolge aufweist.

Die Halbleiterschichtenfolge kann beispielsweise auf einem Substrat ausgebildet werden, wobei vorteilhaft ein n-dotierter Halbleiterbereich auf dem Substrat angeordnet wird. In weiterer Folge können auf dem n-dotierten Halbeiterbereich die aktive Zone und dieser nachfolgend ein p-dotierter Halbleiterbereich angeordnet werden. Der n- und/oder p-dotierte Bereich kann dabei für die in der aktiven Zone generierte Strahlung transparent sein. Erfindungsgemäß wird auf dem p-dotierten Halbleiterbereich eine Kontaktschicht angeordnet, wobei ein Brechungsindex der Kontaktschicht geringer ist als ein Brechungsindex des p-dotierten Halbleiterbereichs. Die Halbleiterschichtenfolge wird mit einer der Kontaktschicht zugewandten Seite auf einem Träger angeordnet. In weiterer Folge ist es vorteilhaft möglich, dass das Substrat vom n-dotierten Halbleiterbereich entfernt wird.

Mittels eines Ätzprozesses, beispielsweise unter Anwendung einer Maske, welche auf dem Träger aufgebracht wird, kann die Halbleiterschichtenfolge in einer Zylinderform ausgeprägt werden. Der Ätzprozess kann im Rahmen eines nasschemischen oder trockenchemischen Prozesses erfolgen und Meseten ausbilden.

Bezüglich der Zylinderachse, welche senkrecht zu einer Schichtebene der Halbleiterschichtenfolge steht, weist die Halbleiterschichtenfolge vorteilhaft eine rotationssymmetrische Außenfläche auf, die im Falle eines Ätzprozesses mit einer Maske vorteilhaft der Außenform der Maske entspricht. Durch eine ausreichende Präzision des Ätzprozesses ergeben sich glatte und homogene Außenflächen der Zylinderform. Durch glatte und homogene Außenflächen wird eine Totalreflexion von Strahlung innerhalb der aktiven Zone vorteilhaft begünstigt, wodurch eine Resonatorwirkung für Strahlung in der aktiven Zone verbessert wird. Die Genauigkeit der Ausbildung der Zylinderform, also der rotationssymmetrischen Form, kann vorteilhaft bei der Durchführung des Ätzprozesses angepasst werden.

Bei dem Verfahren wird weiterhin eine Austrittsstelle für die in der aktiven Zone im Betrieb der Halbleiterlaserdiode erzeugte Strahlung an einer Außenfläche der aktiven Zone ausgebildet, so dass die Strahlung senkrecht zur Zylinderachse der Halbleiterschichtenfolge durch die Austrittsstelle emittiert wird.

Weiterhin ist es möglich mehrere Austrittsstellen an der aktiven Zone für die Strahlung zu erzeugen.

Das Ausbilden der Austrittsstelle kann während dem Formprozess der Zylinderform oder nach diesem erfolgen.

Gemäß zumindest einer Ausführungsform des Verfahrens umfasst die Halbleiterschichtenfolge eine p-dotierte Halbleiterschicht und nach dem Aufwachsen auf dem Substrat wird eine Kontaktschicht auf der p-dotierten Halbleiterschicht angeordnet, die Halbleiterschichtenfolge mit einer dem Substrat abgewandten Seite auf einem Träger angeordnet, und danach das Substrat von der Halbleiterschichtenfolge entfernt. Bei dem Substrat handelt es sich vorteilhaft um ein Aufwachssubstrat für die Halbleiterschichtenfolge.

Gemäß zumindest einer Ausführungsform des Verfahrens umfasst die Kontaktschicht ITO oder ZnO.

Gemäß zumindest einer Ausführungsform des Verfahrens wird die Zylinderform der Halbleiterschichtenfolge mittels eines Lithographieverfahrens erzeugt.

Bei dem Lithographieverfahren wird eine Maske für das Ausbilden der Zylinderform eingesetzt. Die beispielsweise auf die Halbleiterschichtenfolge aufgebrachte Maske kann vorteilhaft zur Vorgabe einer Form der Außenfläche des Zylinders dienen. Ein Ätzprozess erfolgt vorteilhaft aus einer Richtung entlang der Zylinderachse. Es ist hierbei möglich, dass ein auf die Halbleiterschichtenfolge aufgebrachter p-Kontakt als Hartmaske für den Lithographieprozess dient.

Gemäß zumindest einer Ausführungsform des Verfahrens wird an der Austrittsstelle eine Abweichung von der Zylinderform der Außenfläche der aktiven Zone während des Lithographieverfahrens hergestellt.

Die Austrittsstelle kann beispielsweise so ausgeprägt werden, dass diese eine Abweichung von der Zylinderform der Außenfläche der aktiven Zone aufweist, was eine Auskopplung von in der aktiven Zone im Betrieb erzeugten Strahlung begünstigt.

Hierbei können vorteilhaft alle denkbaren Oberflächenformen, beispielsweise konkave oder konvexe Bogenformen oder auch Aufrauungen gebildet werden. Solche Abweichungen von der Rotationssymmetrie können vorteilhaft während dem Herstellungsprozess der Halbleiterschichtenfolge, insbesondere während dem Ausprägen der Zylinderform, erfolgen. Beispielsweise wird beim Herstellen der Zylinderform mittels eines Ätzverfahrens der Zylinderform gleichzeitig eine Deformation in der Zylinderform im Bereich der Austrittsstelle erzeugt.

Gemäß zumindest einer Ausführungsform des Verfahrens wird an der Austrittsstelle nach der Herstellung der Zylinderform der Halbleiterschichtenfolge eine Auskoppelstruktur an der Außenfläche angeordnet.

Die Austrittsstelle kann als eine Auskoppelstruktur zur Auskopplung der in der aktiven Zone im Betrieb erzeugten Strahlung gebildet werden, wobei die Auskoppelstruktur vorteilhaft ein von der aktiven Zone verschiedenes Material mit einem von der aktiven Zone verschiedenen Brechungsindex aufweist. Somit kann in einfacher Weise die Totalreflexion an einer bestimmten Stelle der Außenfläche der aktiven Zone verringert werden. Vorteilhaft bildet die Außenfläche der aktiven Zone im Bereich der aktiven Zone entlang der Zylinderachse zumindest stellenweise eine Außenfläche der Halbleiterlaserdiode und die Auskoppelstruktur wird vorteilhaft in diesem Bereich angeordnet.

Dabei umfasst die aktive Zone vorteilhaft eine Passivierung oder einen p-dotierten Bereich an der Außenfläche zur Verminderung nichtstrahlender Elektron-Loch-Rekombinationen, wobei die Auskoppelstruktur auf dieser Passivierung oder den p-dotierten Bereich angeordnet wird.

Bei der Auskoppelstruktur kann es sich um eine dielektrische Schicht und/oder um eine plasmonische Struktur handeln.

Gemäß zumindest einer Ausführungsform des Verfahrens wird die Halbleiterschichtenfolge epitaktisch auf einem Substrat aufgewachsen.

Beispielsweise wird in einem Dünnfilmprozess ein n-dotiertes Halbleitermaterial auf einem Aufwachssubstrat aufgewachsen. Im weiteren Epitaxieprozess werden eine aktive Zone und ein p-dotiertes Halbleitermaterial auf das n-dotierte Halbleitermaterial aufgewachsen. Nachträglich kann die Halbleiterschichtenfolge mit n- und p-Kontakten versehen werden und vorteilhaft auf einen Träger mit dem p-dotierten Halbleitermaterial umgebondet werden und das Aufwachssubstrat wieder entfernt werden.

Weitere Vorteile, vorteilhafte Ausführungsformen und Weiterbildungen ergeben sich aus dem im Folgenden in Verbindung mit den Figuren beschriebenen Ausführungsbeispiel.

Es zeigen:
Figur 1 eine Halbleiterlaserdiode in Zylinderform,
Figuren 2a und 2b eine schematische Draufsicht auf die aktive Zone, welche einen Resonator für die Strahlung darstellt, und
Figuren 3a und 3b die Halbleiterlaserdiode in einer schematischen Seitenansicht während des Herstellungsverfahrens.

Gleiche oder gleichwirkende Elemente sind in den Figuren jeweils mit den gleichen Bezugszeichen versehen. Die in den Figuren dargestellten Bestandteile sowie die Größenverhältnisse der Bestandteile untereinander sind nicht als maßstabsgerecht anzusehen.

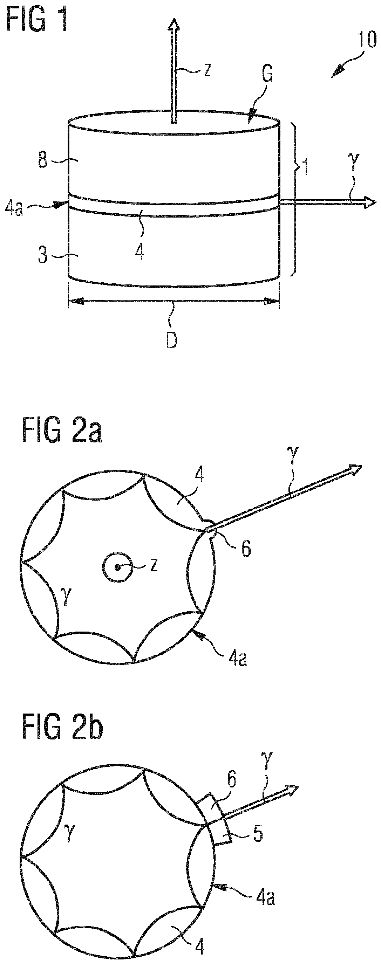

Die Figur 1 zeigt die Halbleiterschichtenfolge 1 der Halbleiterlaserdiode 10 in einer schematischen Ansicht, wobei die Halbleiterschichtenfolge 1 einen n-dotierten Halbeiterbereich 3, eine aktive Zone 4 und einen p-dotierten Halbeiterbereich 8 umfasst. Die p- und n-dotierten Halbeiterbereiche sowie die aktive Zone können vorteilhaft auf III-V-Halbleitermaterialien basierende Halbleiterschichten umfassen. Beispielsweise basieren die Halbleiterschichten auf einem Nitrid-Verbindungshalbleitermaterial wie AlₙIn₁₋ₙGaₘN oder auf einem Phosphid-Verbindungshalbleitermaterial wie AlₙIn₁₋ₙGaₘP oder auf einem Arsenid-Verbindungshalbleitermaterial AlₙIn₁₋ₙGaₘAs, wobei jeweils 0 ≤ n ≤ 1, 0 ≤ m ≤ 1 und n+m ≤ 1 gilt. Dabei kann dieses Material einen oder mehrere Dotierstoffe sowie zusätzliche Bestandteile aufweisen.

Die aktive Zone 4 umfasst beispielsweise eine Einfachquantentopfstruktur oder eine Mehrfachquantentopfstruktur zum effektiven Generieren einer stimulierten Emission in der Halbleiterlaserdiode 10. Insbesondere weist die aktive Zone 4 weniger oder gleich 10 Quantentopfstrukturen auf.

Weiterhin zeigt die Figur 1 eine rotationssymmetrische, insbesondere kreisförmige, Außenfläche 4a der aktiven Zone 4. Dabei weisen vorteilhaft auch die p- und n-dotierten Halbeiterbereiche 3 und 8 entsprechend der aktiven Zone rotationssymmetrische, insbesondere kreisförmige, Außenflächen bezüglich einer Zylinderachse z auf. Die Zylinderachse z steht senkrecht auf Schichtebenen der Halbleiterschichtenfolge 1.

Die Figur 1 zeigt weiterhin eine Abstrahlung von Strahlung y, welche im Betrieb der Halbleiterlaserdiode 10 in der aktiven Zone 4 erzeugt wird und in eine Richtung senkrecht zur Zylinderachse z der Halbleiterschichtenfolge 1 aus der aktiven Zone 4 abgestrahlt wird.

Die Zylinderform der Halbleiterschichtenfolge 1 ist verhältnismäßig kleinskalig ausgebildet, beispielsweise umfassend eine Grundfläche G des Zylinders mit einem Durchmesser D von 1 µm bis 100 µm.

Bis auf die Stelle, an welcher die Strahlung γ aus der Halbleiterschichtenfolge 1 austritt weist die aktive Zone 4 eine Außenfläche 4a auf, welche besonders glatt ist und eine mit hoher Präzision ausgebildete Zylindermantelform aufweist, mit anderen Worten nahezu keine Abweichung von der Rotationsssymmetrie, insbesondere der Kreisform, des Zylinders aufweist. Vorteilhaft weisen die Außenfläche 4a der aktiven Zone 4 und die Außenflächen der p- und n-dotierten Halbeiterbereiche 3 und 8 in Draufsicht aus der Richtung der Zylinderachse z eine Kreisform auf.

Die Figur 2a zeigt aktive Zone 4 in einer schematischen Draufsicht aus einer Richtung entlang der Zylinderachse z. Für die in der aktiven Zone 4 erzeugte Strahlung y wirkt die Außenfläche 4a der aktiven Zone 4 als Resonator, nachdem die Strahlung y an der Außenfläche 4a durch Totalreflexion reflektiert wird. Hierbei bildet sich eine sogenannte "Whispering Gallery Mode" aus. Der Grad der Totalreflexion ist umso besser, je genauer der Verlauf der Außenfläche 4a der Zylinderform der Halbleiterschichtenfolge bzw. einer Kreisform mit Symmetrie bezüglich der Zylinderachse z entspricht. An einer Stelle, welche zur Abstrahlung der Strahlung y aus der aktiven Zone 4 vorgesehen ist, weicht die Form der Außenfläche 4a von der Zylinderform bzw. von der Kreisform ab. Dies ist an der Austrittsstelle 6 der Fall. Im Bereich der Austrittsstelle 6 weist die Außenfläche 4a beispielsweise eine Abweichung von der Zylinderform bzw. von der Kreisform oder eine Aufrauung auf. Dadurch wird eine Auskopplung und Abstrahlung der Strahlung y aus der aktiven Zone 4 senkrecht zur Zylinderachse z erzielt.

In der Figur 2b ist eine Draufsicht auf die aktive Zone 4 entsprechend der Figur 2a gezeigt mit dem Unterschied, dass die aktive Zone 4 im Bereich der Austrittsstelle 6 eine Auskoppelstruktur 5 aufweist. Bei der Auskoppelstruktur 5 kann es sich um eine dielektrische Schicht und/oder um eine plasmonische Struktur handeln. Die plasmonische Struktur umfasst vorteilhaft eine nanoskalige Metallstruktur in Form eines Kreises, Rechtecks oder einer Gitterstruktur. Die Auskoppelstruktur 5 ist im Bereich der Austrittsstelle 6 auf die Außenfläche 4a der aktiven Zone 4 vorteilhaft aufgebracht oder in die aktive Zone eingearbeitet. Die Auskoppelstruktur 5 als dielektrische Schicht weist gegenüber der aktiven Zone einen Unterschied im Brechungsindex auf, wodurch an dieser Stelle die Totalreflexion für die Strahlung y in der aktiven Zone 4 verringert ist und der Anteil an ausgekoppelter Strahlung durch die Auskoppelstruktur 5 vergrößert ist. Die Auskoppelstruktur 5 kann nachträglich auf der fertiggestellten Halbleiterschichtenfolge angeordnet werden.

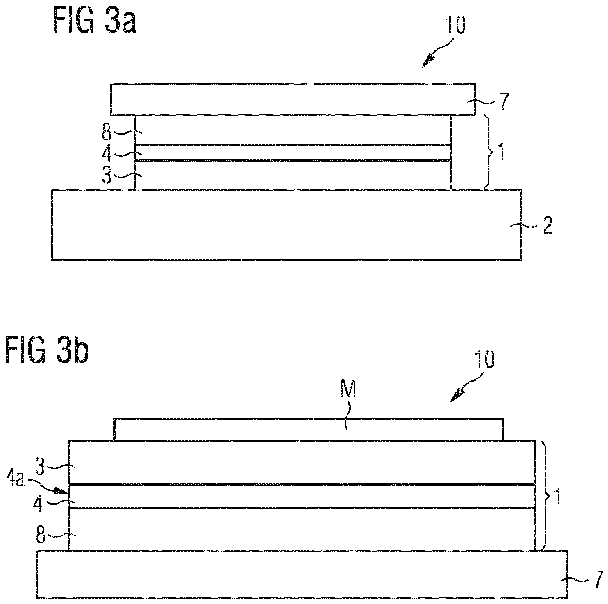

Die Figur 3a zeigt in einer schematischen Seitenansicht die Halbleiterlaserdiode 10 mit der Halbleiterschichtenfolge 1 während eines Herstellungsprozesses. Auf ein Substrat 2 wird eine Abfolge von Halbleiterschichten, beispielsweise epitaktisch, angeordnet. Weiterhin wird eine aktive Zone 4 und dieser nachfolgend ein p-dotierter Halbleiterbereich 8 auf dem n-dotierten Halbleiterbereich 3 angeordnet, vorteilhaft aufgewachsen, so dass die Halbleiterschichten zueinander parallele Schichtebenen aufweisen.

In einem weiteren Verfahrensschritt wird ein Träger 7 auf der dem Substrat 2 abgewandten Seite des p-dotierten Halbleiterbereichs 8 angeordnet. Für eine Kontaktierung kann der Träger vorteilhaft einen p-Kontakt umfassen und die Halbleiterschichtenfolge auf den Träger umgebondet werden.

Die Figur 3b zeigt die Anordnung der Halbleiterschichtenfolge 1 gemäß der Figur 3a, wobei nachträglich in einem weiteren Verfahrensschritt das Substrat von der Halbleiterschichtenfolge 1 entfernt wurde und danach der n-dotierte Halbleiterbereich 3 freiliegt. Als verbleibendes tragendes Element der Halbleiterschichtenfolge 1 dient danach der Träger 7. In einem weiteren Verfahrensschritt wird eine Maske M auf dem n-dotierten Halbleiterbereich 3 angeordnet.

Die Maske M dient beispielsweise zur Durchführung eines Lithographieschrittes, wobei die Maske M in Draufsicht gesehen beispielsweise eine kreisrunde Form aufweist und durch einen Ätzprozess die Halbleiterschichtenfolge 1 in die zylindrische Form gebracht wird. Durch einen präzisen Ätzprozess wird die Kreisform der Maske M auf die Außenflächen der Halbleiterschichtenfolge 1 übertragen, so dass die Kreisform der Außenfläche 4a der aktiven Zone 4 eine Totalreflexion von Strahlung innerhalb der aktiven Zone begünstigt. Die Figur 3b zeigt die Halbleiterschichtenfolge 1 nach dem Anordnen der Maske M und vor der Durchführung des Ätzprozesses.

Es ist möglich, dass für den Ätzprozess in einem für die Austrittsstelle vorgesehenen Bereich die Maske M eine Abweichung von der Kreisform aufweist. Somit kann gleichzeitig mit dem Ätzprozess eine Austrittsstelle für die Strahlung an der aktiven Zone erzeugt werden, bei welcher die Außenfläche 4a der aktiven Zone 4 von der Kreisform abweicht.

Eine Passivierung kann vorteilhaft im Nachhinein auf der Außenfläche der aktiven Zone angeordnet werden.

### Bezugszeichenliste

- 1: Halbleiterschichtenfolge
- 2: Substrat
- 3: n-dotierter Halbleiterbereich
- 4: aktiven Zone
- 4a: Außenfläche
- 5: Auskoppelstruktur
- 6: Austrittsstelle
- 7: Träger
- 8: p-dotierter Halbleiterbereich
- 10: Halbleiterlaserdiode
- D: Durchmesser
- y: Strahlung
- G: Grundfläche
- M: Maske
- z: Zylinderachse

## Patentansprüche

1. Halbleiterlaserdiode (10) mit einer Halbleiterschichtenfolge (1) umfassend eine aktive Zone (4), wobei
- die Halbleiterschichtenfolge (1) eine p-dotierte Halbleiterschicht (8) umfasst und auf dieser eine Kontaktschicht angeordnet ist,
- ein Brechungsindex der Kontaktschicht geringer ist als ein Brechungsindex der p-dotierten Halbleiterschicht,
- an einer der Kontaktschicht zugewandten Seite der Halbleiterlaserdiode ein Träger (7) angeordnet ist,
- die Halbleiterschichtenfolge (1) zylinderförmig ist,
- eine Zylinderachse (z) der Halbleiterschichtenfolge (1) senkrecht zu einer Schichtebene der Halbleiterschichtenfolge (1) ist, und
- die Halbleiterlaserdiode (10) eine im Betrieb erzeugte Strahlung senkrecht zur Zylinderachse (z) der Halbleiterschichtenfolge (1) emittiert.

2. Halbleiterlaserdiode (10) nach Anspruch 1,
bei der die aktive Zone (4) eine bezüglich der Zylinderachse (z) symmetrische Außenfläche (4a) umfasst, welche im Betrieb der Halbleiterlaserdiode (10) durch Totalreflexion von in der aktiven Zone (4) erzeugter Strahlung einen Resonator ausbildet.

3. Halbleiterlaserdiode (10) nach Anspruch 2,
bei der die Außenfläche (4a) eine Austrittsstelle (6) für die in der aktiven Zone (4) im Betrieb erzeugte Strahlung umfasst.

4. Halbleiterlaserdiode (10) nach Anspruch 3,
bei der die Außenfläche (4a) der aktiven Zone (4) an der Austrittsstelle (6) eine Abweichung von der Zylinderform aufweist, durch welche die in der aktiven Zone (4) im Betrieb erzeugte Strahlung aus der Halbleiterlaserdiode (10) austritt.

5. Halbleiterlaserdiode (10) nach Anspruch 3 oder 4,
bei der an der Austrittsstelle (6) eine Auskoppelstruktur (5) zur Auskopplung der in der aktiven Zone (4) im Betrieb erzeugten Strahlung angeordnet ist.

6. Halbleiterlaserdiode (10) nach dem vorherigen Anspruch, bei der die Auskoppelstruktur (5) einen von der aktiven Zone (4) verschiedenen Brechungsindex aufweist.

7. Halbleiterlaserdiode (10) nach Anspruch 5,
bei der die Auskoppelstruktur (5) eine dielektrische Schicht und/oder eine plasmonische Struktur umfasst.

8. Halbleiterlaserdiode (10) nach einem der vorhergehenden Ansprüche,
bei der eine Grundfläche der zylinderförmigen Halbleiterschichtenfolge (1) einen Durchmesser von 1 µm bis 100 µm aufweist.

9. Halbleiterlaserdiode (10) nach einem der vorhergehenden Ansprüche,
bei der die aktive Zone (4) eine Einfachquantentopfstruktur oder eine Mehrfachquantentopfstruktur umfasst.

10. Halbleiterlaserdiode (10) nach einem der vorhergehenden Ansprüche,
bei der die Halbleiterschichtenfolge (1) eines der Materialsysteme InGaN, InGaAlP, oder AlGaAs umfasst.

11. Verfahren zur Herstellung einer Halbleiterlaserdiode (10) umfassend die Schritte
- Bereitstellen einer Halbleiterschichtenfolge (1) mit einer aktiven Zone (4) und einer p-dotierten Halbleiterschicht (8),
- Anordnen einer Kontaktschicht auf der p-dotierten Halbleiterschicht, wobei ein Brechungsindex der Kontaktschicht geringer ist als ein Brechungsindex der p-dotierten Halbleiterschicht,
- Anordnen der Halbleiterschichtenfolge (1) mit einer der Kontaktschicht zugewandten Seite auf einem Träger (7),
- Herstellen einer Zylinderform der Halbleiterschichtenfolge (1) mittels eines Ätzprozesses, wobei die Halbleiterschichtenfolge (1) eine Zylinderachse (z) senkrecht zu einer Schichtebene der Halbleiterschichtenfolge (1) aufweist, und
- Ausbilden einer Austrittsstelle (6) für die in der aktiven Zone (4) im Betrieb der Halbleiterlaserdiode (10) erzeugte Strahlung an einer Außenfläche (4a) der aktiven Zone (4), so dass die Strahlung senkrecht zur Zylinderachse (z) der Halbleiterschichtenfolge (1) durch die Austrittsstelle (6) emittiert wird.

12. Verfahren nach Anspruch 11,
bei dem die Halbleiterschichtenfolge (1) epitaktisch auf einem Substrat (2) aufgewachsen wird.

13. Verfahren nach Anspruch 12,
bei dem die Kontaktschicht nach dem Aufwachsen auf dem Substrat (2) auf der p-dotierten Halbleiterschicht angeordnet wird, die Halbleiterschichtenfolge (1) mit einer dem Substrat abgewandten Seite auf dem Träger (7) angeordnet wird, und danach das Substrat (2) von der Halbleiterschichtenfolge (1) entfernt wird.

14. Verfahren nach Anspruch 13,
bei dem die Kontaktschicht ITO oder ZnO umfasst.

15. Verfahren nach einem der vorhergehenden Ansprüche 11 bis 14,
bei dem die Zylinderform der Halbleiterschichtenfolge (1) mittels eines Lithographieverfahrens erzeugt wird.

16. Verfahren nach einem der vorhergehenden Ansprüche 11 bis 15,
bei dem an der Austrittsstelle (6) eine Abweichung von der Zylinderform der Außenfläche (4a) der aktiven Zone (4) während des Lithographieverfahrens hergestellt wird.

17. Verfahren nach einem der vorhergehenden Ansprüche 11 bis 16,
bei dem an der Austrittsstelle (6) nach der Herstellung der Zylinderform der Halbleiterschichtenfolge (1) eine Auskoppelstruktur (5) an der Außenfläche (4a) angeordnet wird.

## Claims

1. Semiconductor laser diode (10) with a semiconductor layer sequence (1) comprising an active zone (4), wherein
- the semiconductor layer sequence (1) comprises a p-doped semiconductor layer (8) and on which a contact layer is arranged,
- a refractive index of the contact layer is smaller than a refractive index of the p-doped semiconductor layer,
- on a side of the semiconductor laser diode facing the contact layer a carrier (7) is arranged,
- the semiconductor layer sequence (1) has a cylindrical shape,
- a cylinder axis (z) of the semiconductor layer sequence(1) is perpendicular to a layer plane of the semiconductor layer sequence (1), and
- the semiconductor laser diode (10) emits radiation generated during operation perpendicular to the cylinder axis (z) of the semiconductor layer sequence (1).

2. Semiconductor laser diode (10) according to claim 1, wherein the active zone (4) comprises a symmetrical outer surface (4a) with respect to the cylinder axis (z), which, during operation of the semiconductor laser diode (10), forms a resonator by total reflection of the radiation generated in the active zone.

3. Semiconductor laser diode (10) according to claim 2, wherein the outer surface (4a) comprises an exit point (6) for the radiation generated in the active zone (4) during operation.

4. Semiconductor laser diode (10) according to claim 3, wherein the outer surface (4a) of the active zone (4) comprises a deviation from the cylindrical shape at the exit point (6), through which the radiation generated in the active zone (4) during operation exits the semiconductor laser diode (10).

5. Semiconductor laser diode (10) according to claim 3 or 4,
wherein an outcoupling structure (5) is arranged at the exit point (6) for outcoupling of the radiation generated in the active zone (4) during operation.

6. Semiconductor laser diode (10) according to the preceding claim,
wherein a refractive index the outcoupling structure (5) is different than a refractive index of the active zone (4) .

7. Semiconductor laser diode (10) according to claim 5, wherein the outcoupling structure (5) comprises a dielectric layer and/or a plasmonic structure.

8. Semiconductor laser diode (10) according to one of the preceding claims,
wherein a base of the cylindrical semiconductor layer sequence (1) has a diameter from 1 µm to 100 µm.

9. Semiconductor laser diode (10) according to one of the preceding claims,
wherein the active zone (4) comprises a single quantum well structure or a multi quantum well structure.

10. Semiconductor laser diode (10) according to one of the preceding claims,
wherein the semiconductor layer sequence (1) comprises one of the material systems InGaN, InGaAlP or AlGaAs.

11. Method for producing a semiconductor laser diode (10) comprising the steps of
- providing a semiconductor layer sequence (1) with an active zone (4) and a p-doped semiconductor layer (8),
- arranging a contact layer on the p-doped semiconductor layer, wherein a refractive index of the contact layer is smaller than a refractive index of the p-doped semiconductor layer,
- arranging the semiconductor layer sequence (1) with a side facing the contact layer on a carrier (7),
- producing a cylindrical shape of the semiconductor layer sequence (1) by an etching process, wherein the semiconductor layer sequence (1) comprises a cylinder axis (z) perpendicular to a layer plane of the semiconductor layer sequence (1), and
- forming an exit point (6) for the radiation generated in the active zone (4) during operation of the semiconductor laser diode (10) on an outer surface (4a) of the active zone (4), such that the radiation is emitted perpendicular to the cylinder axis (z) of the semiconductor layer sequence (1).

12. Method according to claim 11,
wherein the semiconductor layer sequence (1) is epitaxially grown on a substrate (2).

13. Method according to claim 12,
wherein the contact layer is arranged on the p-doped semiconductor layer after growing on the substrate (2), the semiconductor layer sequence (1) is arranged on the carrier (7) on a side facing away from the substrate, and subsequent the substrate (2) is removed from the semiconductor layer sequence (1).

14. Method according to claim 13,
wherein the contact layer comprises ITO oder ZnO.

15. Method according to one of the preceding claims 11 to 14,
wherein the cylindrical shape of the semiconductor layer sequence (1) is produced by a lithography method.

16. Method according to one of the preceding claims 11 to 15,
wherein a deviation from the cylindrical shape of the outer surface (4a) of the active zone is produced during the lithography method at the exit point (6).

17. Method according to one of the preceding claims 11 to 16,
wherein an outcoupling structure (5) is arranged on the outer surface (4a) at the exit point (6) after the production of the cylindrical shape of the semiconductor layer sequence (1).

## Revendications

1. Diode laser à semi-conducteur (10) avec une succession de couches à semi-conducteurs (1) comportant une région active (4), sachant que
- la succession de couches à semi-conducteurs (1) comporte une couche à semi-conducteurs (8) dopée à conduction type p et sur celle-ci est disposée une couche de contact,
- un indice de réfraction de la couche de contact est inférieur à un indice de réfraction de la couche à semi-conducteurs dopée à conduction type p,
- sur un côté de la diode laser à semi-conducteur tourné vers la couche de contact est disposé un support (7),
- la succession de couches à semi-conducteurs (1) est cylindrique,
- un axe cylindrique (z) de la succession de couches à semi-conducteurs (1) est perpendiculaire à un plan de couche de la succession de couches à semi-conducteurs (1), et
- la diode laser à semi-conducteur (10) émet un rayonnement généré en fonctionnement perpendiculairement à l'axe cylindrique (z) de la succession de couches à semi-conducteurs (1).

2. Diode laser à semi-conducteur (10) selon la revendication 1,
pour laquelle la région active (4) comporte une surface extérieure symétrique (4a) par rapport à l'axe cylindrique (z), qui constitue en fonctionnement de la diode laser à semi-conducteur (10) un résonateur par réflexion totale de rayonnement généré dans la région active (4).

3. Diode laser à semi-conducteur (10) selon la revendication 2,
pour laquelle la surface extérieure (4a) comporte une zone de sortie (6) pour le rayonnement généré en fonctionnement dans la région active (4).

4. Diode laser à semi-conducteur (10) selon la revendication 3,
pour laquelle la surface extérieure (4a) de la région active (4) présente sur la zone de sortie (6) une divergence de la forme cylindrique, par laquelle le rayonnement généré dans la région active (4) en fonctionnement sort de la diode laser à semi-conducteur (10) .

5. Diode laser à semi-conducteur (10) selon les revendications 3 ou 4,
pour laquelle sur la zone de sortie (6) est disposée une structure de déclenchement (5) en vue du déclenchement du rayonnement généré en fonctionnement dans la région active (4).

6. Diode laser à semi-conducteur (10) selon la revendication précédente,
pour laquelle la structure de déclenchement (5) présente un indice de réfraction différent de la région active (4) .

7. Diode laser à semi-conducteur (10) selon la revendication 5,
pour laquelle la structure de déclenchement (5) comporte une couche diélectrique et/ou une structure plasmonique.

8. Diode laser à semi-conducteur (10) selon une quelconque des revendications précédentes,
pour laquelle une surface de base de la succession de couches à semi-conducteurs cylindrique (1) présente un diamètre de 1 µm à 100 µm.

9. Diode laser à semi-conducteur (10) selon une quelconque des revendications précédentes,
pour laquelle la région active (4) comporte une structure de puits quantique simple ou une structure de puits quantique multiple.

10. Diode laser à semi-conducteur (10) selon une quelconque des revendications précédentes,
pour laquelle la succession de couches à semi-conducteurs cylindrique (1) comporte un des systèmes de matériaux InGaN, InGaAlP, ou AlGaAs.

11. Procédé en vue de la fabrication d'une diode laser à semi-conducteur (10) comprenant les étapes de
- mise à disposition d'une succession de couches à semi-conducteurs (1) avec une région active (4) et une couche à semi-conducteurs dopée à conduction type p (8),
- disposition d'une couche de contact sur la couche à semi-conducteurs dopée à conduction type p, sachant qu'un indice de réfraction de la couche de contact est inférieur à un indice de réfraction de la couche à semi-conducteurs dopée à conduction type p,
- disposition de la succession de couches à semi-conducteurs (1) avec un côté tourné vers la couche de contact sur un support (7),
- fabrication d'une forme cylindrique de la succession de couches à semi-conducteurs (1) au moyen d'un processus de décapage, sachant que la succession de couches à semi-conducteurs (1) présente un axe cylindrique (z) perpendiculaire à un plan de couche de la succession de couches à semi-conducteurs (1), et
- formation d'une zone de sortie (6) pour le rayonnement généré dans la région active (4) en fonctionnement de la diode laser à semi-conducteur (10) sur une surface extérieure (4a) de la région active (4), de sorte que le rayonnement est émis perpendiculairement à l'axe cylindrique (z) de la succession de couches à semi-conducteurs (1) à travers la zone de sortie (6).

12. Procédé selon la revendication 11,
pour lequel la succession de couches à semi-conducteurs (1) est faite pousser épitaxialement sur un substrat (2) .

13. Procédé selon la revendication 12,
pour lequel la couche de contact est disposée après l'épitaxie sur le substrat (2) sur la couche à semi-conducteurs dopée à conduction type p, la succession de couches à semi-conducteurs (1) est disposée avec un côté détourné du substrat sur le support (7), et ensuite le substrat (2) est ôté de la succession de couches à semi-conducteurs (1).

14. Procédé selon la revendication 13,
pour lequel la couche de contact comporte de l'ITO ou du ZnO.

15. Procédé selon une quelconque des revendications précédentes 11 à 14,
pour lequel la forme cylindrique de la succession de couches à semi-conducteurs (1) est générée au moyen d'un procédé de lithographie.

16. Procédé selon une quelconque des revendications précédentes 11 à 15,
pour lequel, sur la zone de sortie (6) est fabriquée une divergence de la forme cylindrique de la surface extérieure (4a) de la région active pendant le procédé de lithographie.

17. Procédé selon une quelconque des revendications précédentes 11 à 16,
pour lequel, sur la zone de sortie (6) est disposée après la fabrication de la forme cylindrique de la succession de couches à semi-conducteurs (1) une structure de déclenchement (5) sur la surface extérieure (4a) .
